# EUROPEAN PATENT SPECIFICATION

(11) **EP 0 694 929 B1**
(45) Date of publication and mention of the grant of the patent: **26.05.1999**
(21) Application number: 95111283.8
(22) Date of filing: 18.07.1995
(51) Int. Cl.: H01C 1/14, H01C 7/02

(54) **Thermistor for surface mounting**
Thermistor für Oberflächen-Bestückung
Thermistor pour montage en surface

(30) Priority: 18.07.1994 JP 165522/94; 03.10.1994 JP 239141/94
(43) Date of publication of application: 31.01.1996
(73) Proprietor: MURATA MANUFACTURING CO., LTD., Nagaokakyo-shi Kyoto-fu 226 (JP)
(72) Inventor: Katsuki, Takayo, c/o Murata Manufacturing Co., Ltd, Nagaokakyo-shi, Kyoto-fu (JP); Takaoka, Yuichi, c/o Murata Manufacturing Co., Ltd, Nagaokakyo-shi, Kyoto-fu (JP); Torii, Kiyofumi, c/o Murata Manufacturing Co., Ltd, Nagaokakyo-shi, Kyoto-fu (JP); Toba, Akira c/o Murata Manufacturing Co., Ltd, Nagaokakyo-shi, Kyoto-fu (JP); Watanabe, Osamu, c/o Murata Manufacturing Co., Ltd, Nagaokakyo-shi, Kyoto-fu (JP); Tatsuoka, Kouichi, Murata Manufacturing Co., Ltd., Nagaokakyo-shi, Kyoto-fu (JP); Nakagawa, Masaru, Murata Manufacturing Co., Ltd., Nagaokakyo-shi, Kyoto-fu (JP); Yokota, Masahiro, Murata Manufacturing Co., Ltd., Nagaokakyo-shi, Kyoto-fu (JP); Omura, Shinji, Murata Manufacturing Co., Ltd., Nagaokakyo-shi, Kyoto-fu (JP); Ohta, Hiroshi, Murata Manufacturing Co., Ltd., Nagaokakyo-shi, Kyoto-fu (JP)
(74) Representative: Schoppe, Fritz, Dipl.-Ing.

(56) References cited:
- DE-A- 3 638 342
- GB-A- 2 146 488

## Description

This invention relates to electronic apparatus for surface-mounting and surface mounting devices for such apparatus. More particularly, this invention relates, on one hand, to electronic apparatus adapted for surface mounting such as thermistors for controlling a current and, on the other hand, to surface mounting devices for such an electronic apparatus having a pair of electrodes on its upper and lower surfaces.

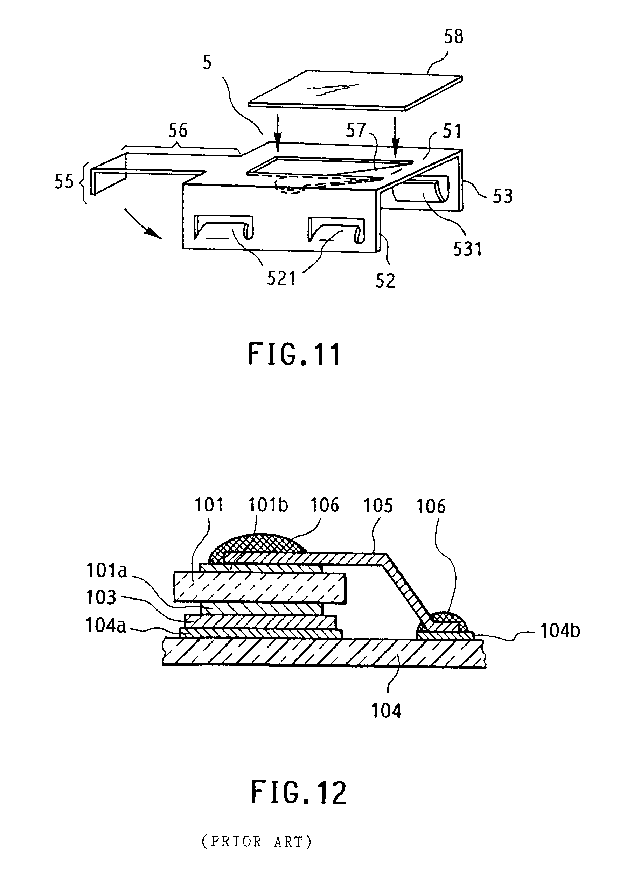

Consider, for example, a positive temperature coefficient (PTC) thermistor element as shown at 101 in Fig. 12, as an example of a planar ceramic electronic element having a pair of ohmic electrodes 101a and 101b on its lower and upper surfaces. The PTC element may be a disk with thickness 3mm and diameter 6-10mm. A prior art method of mounting such an element to a printed circuit board was to provide connector electrodes (say, of silver) on the ohmic electrodes 101a and 101b, to attach lead lines to these connector electrodes and to attach the element to the circuit board through these lead lines. For providing compact apparatus, however, such elements are now mounted directly to the circuit board.

For this purpose, a printed circuit board 104 as shown in Fig. 12 with contact electrodes 104a and 104b may be provided, cream solder 103 may be applied over the circuit board electrode 104a before the element 101 is placed thereon, and its ohmic electrode 101a on the lower surface is connected to the contact electrode 104a by reflow soldering. Next, one end of an electro-conductive lead line 105 is soldered to the other electrode 101b on the upper surface of the element 101, the other end of the lead line 105 being soldered to the other contact electrode 104b. In Fig. 12, numeral 106 indicates the solder used for the attachment of the lead line 105.

Surface-mounted prior art elements of this kind have many problems. Firstly, two kinds of soldering are required for the mounting, the reflow soldering by which the element 101 is connected to the circuit board 104 and the soldering of the lead line 105 to the circuit board 104 and to the element 101. This makes the mounting a time-consuming process. Secondly, since it is not practically possible to simultaneously carry out the soldering of both electrodes 101a and 101b on the two principal surfaces of the element 101, the heat from the first soldering of the lower-surface electrode 101a affects adversely the soldering of the upper-surface electrode 101b. The situation would not change if the order of soldering were reversed, because the soldering characteristics of the electrode to be soldered later are adversely affected. Thirdly, since the ceramic element 101, which is sensitive to heat, is heated twice, micro-cracks are likely to be generated due to the thermal stress. Fourthly, since the element 101 generates heat when it is operated, the generated heat is directly transmitted to the circuit board 104 and through the circuit board 104 to other electronic elements which may be mounted thereon, adversely affecting their performance.

DE 3638342A1 concerns an electronic ceramic device, like a capacitor, a NTC- or PTC-resistor. Specific portions of the surfaces of the ceramic body of the electronic device are formed as contact areas on which metal layers are provided. The device is arranged inside an insulating cover and contact are contact the metal layers on the ceramic body and extend through the insulating cover to the underneath of a bottom wall of the cover to thus provide for a surface-mountable device.

It is the object of the present invention to provide a thermistor which is adapted for surface mounting and has a better heat dissipation capability.

This object is achieved by a thermistor according to claim 1.

The first terminal member may have a contact point part at a position elevated from the bottom member of the case, holding the thermistor element thereon. The first and second terminal members may be bent to have their lower ends positioned on the lower surface of the bottom member of the case. The top part of the case may be formed with an inner top edge part and an outer top edge part, the inner top edge part being inside and lower than the outer top edge part, edge portions of the planar cover part being placed on the inner top edge part and the outer top edge part being bent over the edge portions of the planar cover to secure it to the case. Alternatively, the top edge part of the case may be provided with upward protrusions thereon, the planar cover part having throughholes formed therethrough correspondingly to these protrusions such that the protrusions can be inserted into the throughholes and the planar cover part can thus be secured to the case.

The first terminal member may comprise a flexible material bent by 180 degrees, having a contact point part at one end thereof contacting the thermistor element.

The first conductive member may be in part buried in this insulative case. The first conductive member includes a first compression contact part for being pressed against the lower-surface electrode of the electronic element on the bottom member of the case and a first connector part on the bottom surface of the case. The second conductive member includes a second compression contact part attached to an upper part of the case for being pressed against the upper-surface electrode of the electronic element and a second connector part which extends on a side surface of the case and reaches the bottom surface of the case. The first compression contact part may be provided with one or more protrusions for pressing the lower-surface electrode. The case may be provided with engaging mechanisms on its mutually opposite side surfaces, and the second conductive member with a planar part for covering the case from above and vertically extending parts which cover its side walls and engage with these engaging mechanism so as to be securely attached to the case. The second conductive member may comprise a flexible material, the second compression contact part being bent substantially by 180 degrees from the planar part. The case may further comprise means for preventing motion of the planar part with respect to itself.

The accompanying drawings, which are incorporated in and form a part of this specification, illustrate embodiments of the invention and, together with the description, serve to explain the principles of the invention. In the drawings:
Fig. 1 is a sectional side view of a thermistor for surface mounting embodying this invention;
Fig. 2 is a plan view of the thermistor of Fig. 1;
Fig. 3 is a sectional side view of another thermistor for surface mounting embodying this invention;
Fig. 4 is a diagonal view of the case shown in Fig. 3;
Fig. 5 is a diagonal view of the second terminal shown in Fig. 3;
Fig. 6 is a plan view of another electronic apparatus comprising a ceramic material and provided with a surface mounting device embodying this invention;
Fig. 7 is a sectional view of the apparatus of Fig. 6, taken along line 7-7 of Fig. 6;
Fig. 8 is a sectional view of the apparatus of Fig. 6, taken along line 8-8 of Fig. 6;
Fig. 9 is a diagonal view showing a process of assembling the electronic apparatus of Fig. 6;
Fig. 10 is a plan view of a hoop material from which the first lead terminal member of Fig. 7 is produced;
Fig. 11 is a diagonal view of another second lead terminal member embodying the invention; and
Fig. 12 is a partially sectional side view of a prior art thermistor for surface mounting.

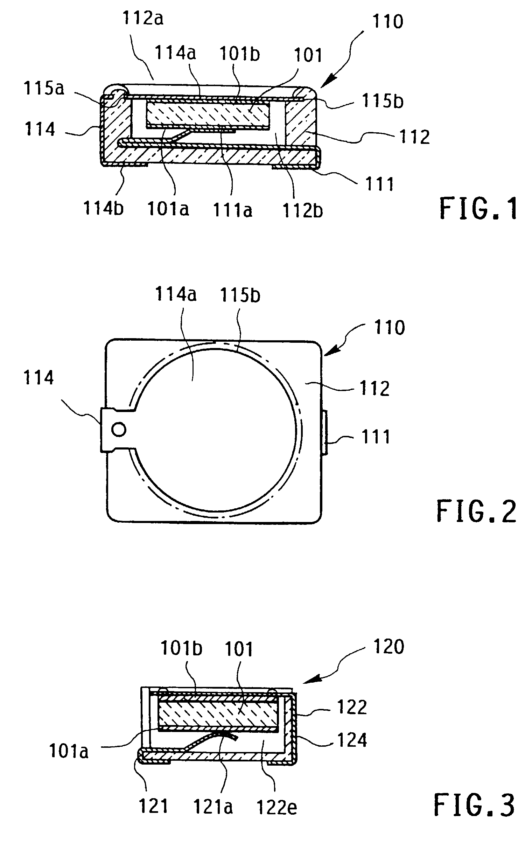

Figs. 1 and 2 show a thermistor 110 according to a first embodiment of this invention adapted for surface mounting, comprising a thermistor element (indicated again by numeral 101, being essentially identical to the element shown in Fig. 12 and described above), a case 112 with a first conductive terminal member 111, and a second conductive terminal member 114. The element 101 is planar, having a pair of electrodes 101a and 101b on its lower and upper surfaces. It may be a PTC thermistor element for current control, a negative temperature coefficient (NTC) thermistor element or a thermistor element which changes its resistance suddenly such as a critical temperature resistor (CTR). The case 112 is of a box-like shape having a bottom member and an opening 112a at be top. The first terminal member 111 extends outward from inside to outside of the case 112. Preferably, the first terminal member 111 has a contact end part llla, which is elastic, is elevated from the upper surface of the bottom member of the case 112, and is bent by 180 degrees to reach the bottom surface of the case 112 by passing on a side surface of the box-like case 112. The edge part of the box-shaped case 112 surrounding its opening 112a at the top has an inner top edge part 115a and an outer top edge part 115b. The outer wall part 115b is somewhat higher than the inner top edge part 115a.

The second conductive terminal member 114 includes a planar cover part 114a, which is dimensioned so as to cover the openings 112a by contacting the inner top edge part 115b of the case 112, and a flat contact part 114b. The thermistor 110 is formed by inserting the thermistor element 101 inside the case 112, closing the opening 112a by causing the planar cover part 114a to contact the inner top edge part 115a of the case 112 from above, deforming the outer top edge part 115b inward to thereby fasten the planar cover part 114a to the case 112. The contact part 114b of the other terminal 114 is guided to the bottom surface of the case 112 through an outer side surface portion of the case 112.

With the thermistor 110 thus formed with its thermistor element 101 mounted inside the case 112, the two electrodes 101a and 101b of this thermistor element 101 are elastically contacted with the contact end part 111a of the first terminal member 111 and the planar cover part 114a of the second terminal member 114, respectively, without being soldered to them, with the contact parts of the two terminal members 111 and 114 disposed at opposite ends on the bottom surface of the case 112. Thus, the thermistor 110 can be mounted to a printed circuit board (not shown) covered with a cream solder, for example, by heating the contact parts on its bottom surface only once in a single soldering step. As shown in Fig. 1, there is a space 112b created between the bottom member of the case 112 and the thermistor element 101 because the contact end part llla of the first terminal member 111 is elevated from the bottom member of the case 112.

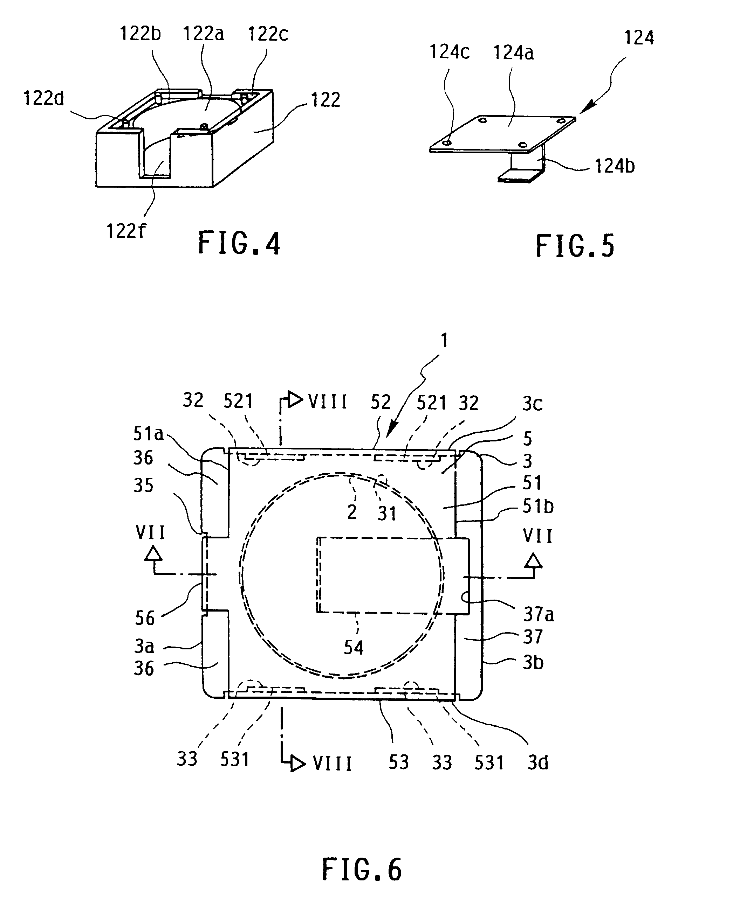

Figs, 3-5 show another thermistor 120 embodying this invention, comprising two conductive terminal members (the first 121 and the second 124) and a case 122, in addition to a thermistor element 101 as described above. The first terminal member 121 is made of an elastic material, having an arcuate contact part 121a at one end and being sectionally U-shaped at the other end. The case 122 is made of an electrically insulating material in a box-like shape with an opening 122a at the top, having therein a space for containing the thermistor element 101. One of the side walls of the box-shaped case 122 has a vertical slit 122f extending down to the bottom so as to be able to accept a downwardly extended portion of the first terminal member 121 therein. The top edge part of the box-shaped case 122 surrounding its top opening 122a has an inner top edge part 122b and an outer top edge part 122c which is somewhat higher than the inner top edge part 122b. A plurality (four in Fig. 4) of upward protrusions 122d are provided on top of the inner top edge part 122b.

The second terminal 124 comprises a planar cover part 124a at one end and a flat contact part 124b at the opposite end, as shown in Fig. 5. The cover part 124a is provided with throughholes 124c corresponding to the aforementioned protrusions 122d for allowing these protrusions 122d to be inserted thereinto.

As shown in Fig. 3, the first terminal member 121 is attached to the case 122 with its arcuate contact part 121a placed above the upper surface of the bottom member of the case 122, and having its U-shaped end part engaging with the bottom member of the case 122. To form the thermistor 120, the thermistor element 101 is inserted into the case 122, the planar cover part 124a of the second terminal member 124 is contacted from above with the inner top edge part 122b, and the outer top edge part 122c of the case 122 is deformed inwardly, after these protrusions 122d are inserted into the throughholes 124c, to secure the cover part 124a of the second terminal member 124 at the opening 122a of the case 122. The flat contact part 124b of the second terminal member 124 is led to the bottom surface of the case 122 opposite from the U-shaped end part of the first terminal member 121.

With the thermistor 120 thus formed with its thermistor element 101 mounted inside the case 122, the two electrodes 101a and 101b of this thermistor element 101 are elastically contacted with the arcuate contact part 121a of the first terminal member 121 and the cover part 124a of the second terminal member 124, respectively. No solder is required for this purpose, and contact end parts of the two terminal members 121 and 124 are both on the bottom surface of the case 122. Thus, the thermistor 120 can be mounted to a printed circuit board (not shown) covered with a cream solder, for example, by heating the contact end parts of the terminal members on its bottom surface only once in a single soldering step. As shown in Fig. 3, there is a space 122e created between the upper surface of the bottom member of the case 122 and the thermistor element 101 because the arcuate contact part 121a of the first terminal member 121 is elevated from the bottom member of the case 122.

Also, it would be possible that the protrusions 122d of the case 122 are deformed after the protrusions 122d are inserted into the throughholes 124c of the second terminal member 124, to thereby fasten the cover part 124a of the second terminal member 124 to the case 122. In this case, the outer top edge part 122c is unnecessary.

Thermistors for surface mounting according to this invention, as described above by way of examples, can be soldered to a printed circuit board by a single step of reflow soldering because their contact parts for external connection are both on the bottom surface of the case. Since the thermistor element is not directly soldered, heat is not applied to the electrodes of the element. The thermistor element is subjected to a thermal stress only once by the soldering. Since the heat of soldering is communicated to the element only indirectly through an empty space, the rise in the temperature of the element is much reduced, and no cracks are generated thereby. The heat generated by the thermistor element itself, when the thermistor is actually in use, is conducted out to the circuit board through the case. Thus, there are no ill-effects on the circuit board or other electronic elements placed near by.

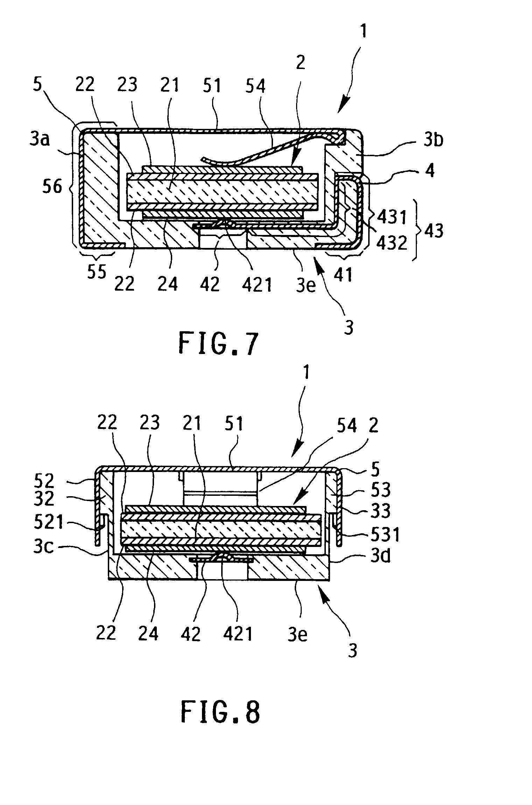

Figs. 6, 7 and 8 are referenced next to describe another electronic apparatus 1 characterized as comprising a ceramic material and being provided with a surface mounting device embodying this invention. More particularly, this apparatus 1 comprises a planar PTC element 2 having a pair of electrodes on its upper and lower surfaces, a case 3 which contains the PTC element 2, a first contact terminal member 4 buried inside a lower part of the case 3 and a second contact terminal member 5 attached to the top surface of the case 3. The PTC element 2 comprises, as shown in Fig. 7, a disc 21 of thickness 2-3mm and diameter 6-10mm made of a barium titanate semiconductive ceramic material, having nickel electrodes 22 on its upper and lower surfaces, and a pair of circular silver electrodes 23 and 24 with diameter slightly smaller than the diameter of the nickel electrodes 22 is sintered onto these nickel electrodes 22. The invention, however, does not require the silver electrodes 23 and 24 to be circular. They may be elliptical, rectangular, polygonal, or of any reasonable shape.

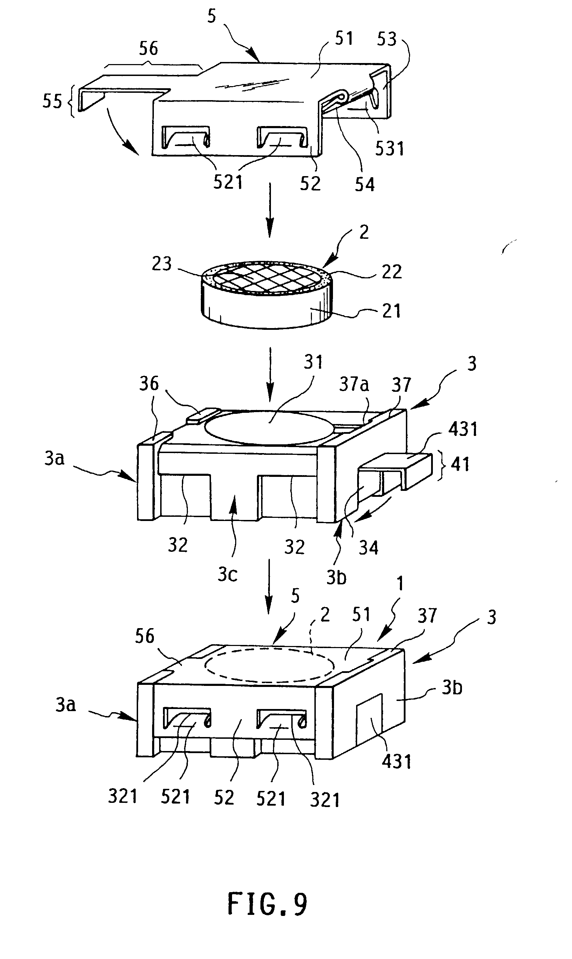

The case 3 is in the shape of a rectangular box, made of a heat-resistant and electrically insulating resin material such as polyphenylene sulfide (PPS) or a liquid crystal polymer (LCP). A cylidrically shaped space 31 for containing the PTC element 2 therein is formed inside the case 3, as shown in Fig. 6, with a diameter slightly greater than that of the PTC element 2. As shown in Figs. 7 and 8, an elastic compression contact part 42 of the first contact terminal member 4 protrudes upward into this inner space 31 from below. Two mutually opposite side walls 3c and 3d are provided with outwardly protruding steps 32 and 33, respectively. The second contact terminal member 5, attached to the top surface of the case 3, are provided with inwardly protruding engagement means 521 and 531 on its side edge parts 52 and 53, respectively, for engaging with the steps 32 and 33. As shown in Figs. 6 and 9, the other pair of mutually opposite side walls 3a and 3b of the case 3 each has a groove 35 or 34 formed at a center part.

The second contact terminal member 5 has a planar part 51, as shown in Fig. 9. In order to limit the motion of this planar part 51 of the second contact terminal member 5, when it is placed on top of the case 3, there are motion-limiting members 36 and 37 provided on the upper surface of the case 3. One of these motion-limiting members (36) is provided in the form of upward protrusions on the upper surface of the case 3 where it is not covered by the planar part 51, with the height about equal to or slightly greater than this planar part 51. The other motion-limiting member 37 has a groove 37a for having this planar part 51 inserted therein. As the second contact terminal member 5 is placed on top of the case 3, side edges of its planar part 51 fit the motion-limiting members 36 and 37 such that it is prevented from moving in the direction of these edges. It now goes without saying that different means for preventing the motion of the planar part 51 with respect to the case 3 may be employed. For example, throughholes may be formed at suitable places through the planar part 51 with protrusions formed on the upper surface of the case 3 corresponding to these throughholes for these protrusions to be inserted thereinto as the planar part 51 is placed on top of the case 3. This method is advantageous in that the motion of the planar part 51 in the longitudinal direction as well as in the transverse direction can be limited and the strength of attachment of the terminal member 5 to the case 3 is improved.

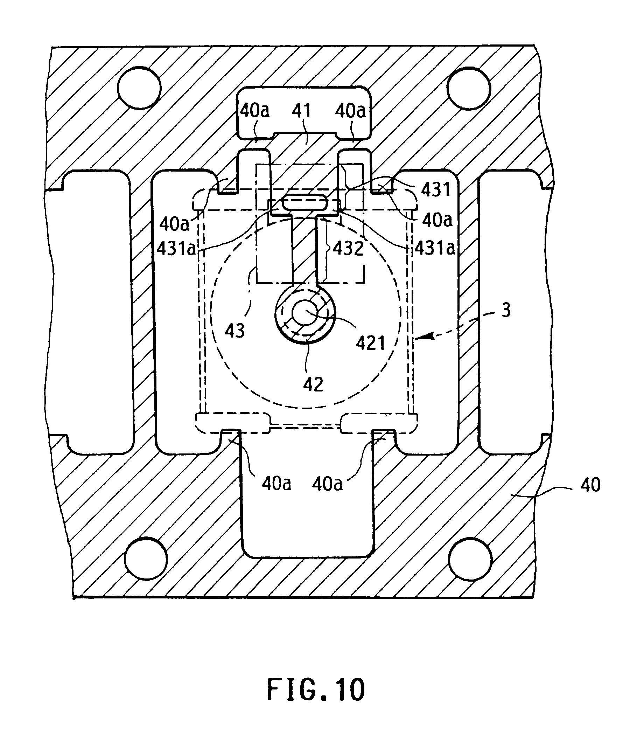

The first contact terminal member 4 is made of an electrically conductive material, comprising an elastic metallic piece such as phosphor bronze, nickel silver or iron with its surfaces plated with tin, silver or the like and is made by bending it into a desired shape, having, as shown in Fig. 10 as well as Fig. 7, a connector terminal part 41 and a circular compression contact part 42 at opposite ends and a lead line part 43 therebetween. The connector terminal part 41 is for connection to an electrode on the printed circuit board to which the apparatus 1 is to be mounted. The compression contact part 42 is for making a contact with the lower-surface electrode 24 of the PTC element 2. The lead line part 43 serves not only to electrically connect the aforementioned connector terminal and compression contact parts 41 and 42 but also as means for radiating off the heat generated by the PTC element 2. As shown in Fig. 10, the lead line part 43 has a wider part 431 and a narrower part 432. The connector terminal part 41 is formed by bending a tip portion of the wider part 431, and the narrower part 432 extends to the compression contact part 42.

The reason for providing the lead line part 43 with a wider part and a narrower part is to more effectively radiate the heat generated by the PTC element 2. In order to reduce the conduction of the generated heat to the connector terminal part 41, the lead line part 43 is made as much longer as possible than the shortest distance by which the positions of the connector terminal and compression contact parts 41 and 42 on the case 3 can be connected. As can be seen in Fig. 7, the the wider and narrower parts 431 and 432 are bent such that a round-about route is formed between the connector terminal and compression contact parts 41 and 42. Described more in detail, the narrower part 432 extends towards the side wall 3b from the compression contact part 42 at a center part of the case 3, makes a 90-degree turn upward before reaching the outer surface to reach its highest point where it is bent again by 90 degrees outward and reaches the outer surface of the side wall 3b. The first lead terminal member 4 is then bent downward, as it is exposed to the exterior, along the outer surface of the side wall 3b inside the vertically formed groove 34 thereon, reaching the bottom surface 3e of the case 3. For this reason, the depth of the aforementioned groove 34 is approximately the same as or greater than the thickness of the wider part 431 so as to prevent it from protruding outward from the outer surface of the side wall 3b. As shown in Fig. 10, an elliptical hole 44 is formed through the wider part 431 where it connects to the narrower part 432 to form a narrow-path region 431a and to thereby reduce heat conduction therethrough. In summary, since the lead line part 43 is stretched from the compression contact part 42 to the bottom surface 3e by making a large upward detour and since a narrow-path region 431a is provided in the wider part 431, the conduction route of heat from the PTC element 2 to the connector terminal part 41 is made as long as practically possible so as to reduce the amount of heat traveling therethrough.

The compression contact part 42 has a circular upward protrusion 421 formed in the middle for making a point contact with the lower-surface electrode 24 of the PTC element 2 such that the heat conduction through this contact to the first lead terminal member 4 will be reduced. It now goes without saying that the protrusion 421 need not be circular in shape but may assume any other reasonable shape such as an ellipse or a rectangle. As another alternative, two or more protrusions may be provided to the compression contact part 42 for making several point contacts with the lower-surface electrode 24, or use may be made of no protrusions to establish a surface contact between the compression contact part 42 and the lower-surface electrode 24 of the PTC element 2. In view of the stability of the PTC element 2 and the contact between the compression contact part 42 and the lower-surface electrode 24, three is the preferred number of protrusions to be provided.

The connector terminal part 41 is generally in the shape of a rectangle as shown in Fig. 10, formed by bending an end portion of the wider part 431 as shown in Fig. 7. Its shape, however, is not limited to be rectangular but may be circular or elliptical. In summary, the first contact terminal member 4 is set by positioning its connector terminal part 41 at a specified end portion of the bottom surface 3e of the case 3 and burying the narrow-path region 431a of the wider part 431 and the narrower part 432 in the side wall 3b so as to be integral with the case 3.

The second contact terminal member 5 is made of an electrically conductive material, comprising a flexible metallic piece such as phosphor bronze, nickel silver, a Cu-Ti alloy or stainless steel with its surfaces plated with tin, silver or the like and is made by bending it into a desired shape, including, as shown in Fig. 7, the planar part 51 for covering the upper surface of the case 3, the side edge parts 52 and 53 for covering portions of the side walls 3c and 3d of the case 3, a compression contact part 54 for pressing down the electrode 23 on the upper surface of the PTC element 2, a connector terminal part 55 for surface mounting, and a lead line part 56 which is elongated like a band to connect the connector terminal part 55 to the upper surface of the case 3. As explained above, the inwardly protruding engagement means 521 and 531 are provided on the side edge parts 52 and 53, respectively, for engaging with the steps 32 and 33 and thereby preventing the second contact terminal member 5 from disengaging from the case 3.

The compression contact part 54 is formed by bending a protruding piece extending from the planar part 51, as shown in Figs. 6 and 7, downward in a hair-pin style such that the free edge of this extending piece will be positioned below a center region of the planar part 51, as shown in Fig. 7. This free edge is slightly bent upward so as to provide a downwardly convex surface by which the upper-surface electrode 23 of the PTC element 2 is pressed downward. Because of this hair-pin style bending, the second contact terminal member 5 functions as a spring such that the reaction to the force of the PTC element 2 to the compression contact part 54 is absorbed and deformation and breakage of the material are prevented. With the hair-pin curvature formed as shown in Fig. 7, the force applied to this bending portion of the second contact terminal member 5 tends to push the compression contact part 54 towards the upper surface of the case 3. This has the favorable effect of keeping the second contact terminal member 5 attached to the case 3.

Fig. 11 shows another terminal member 5' which can replace the second contact terminal member 5 described above as incorporated in the apparatus 1. Parts of this member 5' which are comparable or function equivalently to those of the member 5 described above are indicated by the same numeral for convenience. The member 5' is characterized as having a portion of its planar part 51 cut out to form a compression contact part 57 which is bent downward and including a sealing member 58 attached to the planar part 51 to close the hole created by the compression contact part 57.

The lead line part 56 (whether as a portion of the alternative member 5' shown in Fig. 11 or the second contact terminal member 5 shown in Figs. 6-10) comprises an elongated piece extending from one edge 51a of the planar part 51 and is bent downward into the groove 35 formed at the center of the side wall 3a. Its free edge part is bent along the bottom surface 3e of the case 3 to serve as the connector terminal part 55.

Fig. 9 shows an assembly process for the electronic apparatus 1. The PTC element 2 is placed from above into the space 31 inside the case 3, into the walls of which the first lead terminal member 4 is already partially buried, and the second lead terminal member 5 is placed over it such that its planar part 51 and the side edge parts 52 and 53 will cover the upper and side surfaces of the case 3. For the convenience of the assembly work, the wider part 431 of the first lead terminal member 4 is extended perpendicularly from the side wall 3b of the case 3. Similarly, the lead line part 56 of the second lead terminal member 5 is originally coplanar with the planar part 51 and extended perpendicularly to the side wall 3a of the case 3.

The case 3, into which the first lead terminal member 4 is partially buried, is produced in a plurality of units by punching a belt-like elongated hoop member 40 into a desired shape having a plurality of first lead terminal members 4 connected in a single line as shown in Fig. 10. Each first lead terminal member 4 is placed inside a mold for corresponding one of the cases 3 and a resin material is injected into the molds to unistructurally form the cases 3. Individual cases 3 are produced thereafter by removing connecting parts 40a of the hoop member 40.

When the second lead terminal member 5 is placed over the case 3, as shown in Fig. 9, the compression contact part 54 of the second lead terminal member 5 compresses the upper-surface electrode 23 of the PTC element 2, and the compression contact part 42 of the first lead terminal member 4 compresses the lower-surface electrode 24 of the PTC element 2, thereby holding the PTC element 2 securely inside the internal space 31 of the case 3. At the same time, the engagement means 521 and 531 formed on the side edge plates 52 and 53 slide downward along the side walls 3c and 3d until they engage with the steps 32 and 33 to be locked. In this manner, the second lead terminal member 5 is prevented from moving upward and sandwiched condition of the PTC element 2 between the compression contact parts 42 and 54 is maintained.

The wider part 431 protruding from the side surface 3b of the case 3 and the lead line part 56 extending from the planar part 51 of the second lead terminal member 5 are extended such that the connector terminal part 41 of the first lead terminal member 4 and the connector terminal part 55 of the second lead terminal member 5 are on the bottom surface 3e of the case 3.

Thus, the PTC element 2 is placed inside a container comprising the case 3 and the second lead terminal member 5 and is ready for surface mounting. Since the electronic apparatus 1 for surface mounting is produced merely by assembling the PTC element 2, the first and the second lead terminal members 4, 5 and the case 3 which are all independently and preliminarily produced, the production process is much simplified. Although the invention was described above with reference to a PTC element, it now goes without saying that apparatus containing other kinds of electronic elements such as an NTC element and a piezoelectric element having electrodes on its upper and lower surfaces can be similarly produced according to this invention. The invention, however, is particularly effective for PTC and NTC elements for current control which tend to produce heat at the time of operation.

A surface mounting device, as described above, makes the surface mounting of an electronic apparatus easy. Since the electrodes of the element are not directly connected to the circuit board, the heat at the time of soldering does not damage the ceramic material of the element or its electrodes. If one or more protrusions are provided on the compression contact part of the first lead terminal member, the transfer of heat generated by the electronic element itself to the circuit board is limited such that the ill-effects of such heat on other electronic components placed near by can be reduced. The engaging means on the side walls of the case make the assembly of the apparatus easier. Since the second lead terminal member includes a 180-degree bending, forces applied from the element are absorbed thereby and deformation and breakage of the member can be prevented.

## Claims

1. A thermistor (1;110;l20) for surface mounting comprising:
a planar thermistor element (2;101) having electrodes (22,24;101a,101b) on mutually opposite main surfaces thereof;
a first conductive terminal member (4;111;121) contacting one of said main surfaces;
a case (3;112;122) housing said element (2;101) with a top opening (31;112a;122a) having a top edge part surrounding said top opening (112a;122a) and a bottom member, one end of said first terminal member (111;121) being positioned inside said case (112;122) above said bottom member; and
a second conductive terminal member (5;114;124) having at one end thereof a planar cover (51;114a;124a) which is attached to said top edge part of said case (3;112;122) thereby covering said opening (3;112a;122a) and contacting said other main surface, the other ends of said first and second terminal members (4,5;111,114;121,124) being positioned underneath said bottom member.

2. The thermistor of claim 1 wherein said first terminal member (111;121) has a contact point part (llla;121a) which is at a position elevated from said bottom member, said thermistor element (101) is held at a position elevated from said bottom member, and said first and second terminal members (111,114;121,124) to have said other ends thereof positioned on a bottom surface of said bottom member.

3. The thermistor of claim 1 or 2 wherein said top edge part of said case (112) has an inner top edge part (115a) and an outer top edge part (115b), said inner top edge part (115a) being inside and lower than said outer top edge part (115b), edge portions of said planar cover part (114a) being placed on said inner top edge part (115a) of said case (112), said outer top edge part (115b) being bent over said edge portions of said planar cover to secure said planar cover part (114a) to said top part of said case (112).

4. The thermistor of claim 1 or 2 wherein said top edge part of said case (122) has upward protrusions (122d) formed thereon, said planar cover part (124a) having throughholes (124c) formed therethrough correspondingly to said protrusions (122d), said protrusions (122d) being inserted into said throughholes (124c) to secure said planar cover part (124a) to said case (122).

5. The thermistor of any of claims 1 to 4 wherein said first terminal member (111;124) comprises an elastic material bent by 180 degrees, has a contact point part (111a;121a) at one end thereof contacting said thermistor element (101).

6. The thermistor of claim 1 wherein said thermistor element (101) is a positive temperature coefficient (PTC) thermistor element for current control.

7. The thermistor of claim 1, wherein said thermistor element (101) is a negative temperature coefficient (NTC) thermistor element for current control.

8. The thermistor of claim 1 wherein said thermistor element (101) is a critical temperature resistor (CTR) element for current control.

9. The thermistor of claim 1, wherein said case (3) is electrically insulative and said bottom member has a bottom surface;
said first conductive terminal member (4) is in part buried in said case (3) and includes a first compression contact part (42) and a first connector part, said first compression contact part pressing said lower-surface electrode on said element, said first connector part being on said bottom surface of the case; and
said second conductive terminal member (5) has a second compression contact part (54) and a second connector part, said second compression contact part (54) being attached to an upper part of said case (3) and pressing said upper-surface electrode (22,23), said second connector part (51) being extending on a side surface of said case (3) and reaching said bottom surface of the case.

10. The thermistor of claim 9 wherein said first compression contact part (42) has at least one protrusion formed thereon for pressing said lower-surface electrode.

11. The thermistor of claim 9 or 10 wherein said case (3) has mutually opposite side walls (3c,3d) having engaging mechanisms (32,33) thereon, said second conductive member (5) having a planar part (51) for covering said case (3) from above and vertically extending parts (52,53) which cover said side walls (3c,3d) and engage with said engaging mechanisms (32,33) on said side walls (3c,3d).

12. The thermistor of claim 11 wherein said second conductive member (5) comprising a flexible material, said second compression contact part (54) bent substantially by 180 degrees from said planar part.

13. The thermistor of claim 11 or 12 wherein said case (3) comprises means (36,37) for preventing motion of said planar part with respect thereto.

## Patentansprüche

1. Ein Thermistor (1; 110; 120) zum Oberflächenbefestigen mit folgenden Merkmalen:
einem planaren Thermistorelement (2; 101) mit Elektroden (22, 24; 101a, 101b) auf gegenseitig gegenüberliegenden Hauptoberflächen desselben;
einem ersten leitfähigen Anschlußbauglied (4; 111; 121), das eine der Hauptoberflächen kontaktiert;
einem Gehäuse (3; 112; 122), das das Element (2; 101) häust und eine obere Öffnung (31; 112a; 122a) mit einem oberen Kantenteil, der die obere Öffnung (112a; 122a) umgibt, und ein unteres Bauglied aufweist, wobei ein Ende des ersten Anschlußbauglieds (111; 121) innerhalb des Gehäuses (112; 122) über dem unteren Bauglied positioniert ist; und
einem zweiten leitfähigen Anschlußbauglied (5; 114; 124), das an einem Ende desselben eine planare Abdeckung (51; 114a; 124a) aufweist, die an dem oberen Kantenteil des Gehäuses (3; 112; 122) angebracht ist, um dadurch die Öffnung (3; 112a; 122a) zu bedecken und die andere Hauptoberfläche zu berühren, wobei die anderen Enden des ersten und des zweiten Anschlußbauglieds (4, 5; 111, 114; 121, 124) unter dem unteren Bauglied positioniert sind.

2. Der Thermistor gemäß Anspruch 1, bei dem das erste Anschlußbauglied (111; 121) einen Kontaktpunktteil (111a; 121a) hat, der an einer Position ist, die von dem unteren Bauglied erhöht ist, wobei das Thermistorelement (101) an einer Position gehalten wird, die von dem unteren Bauglied erhöht ist, und wobei die anderen Enden des ersten und des zweiten Anschlußbauglieds (111, 114; 121, 124) an einer unteren Oberfläche des unteren Bauglieds positioniert sind.

3. Der Thermistor gemäß Anspruch 1 oder 2, bei dem der obere Kantenteil des Gehäuses (112) einen inneren oberen Kantenteil (115a) und einen äußeren oberen Kantenteil (115b) hat, wobei der innere obere Kantenteil (115a) innerhalb und niedriger als der äußere obere Kantenteil (115b) ist, wobei Kantenabschnitte des planaren Abdeckungsteils (114a) an dem inneren oberen Kantenteil (115a) des Gehäuses (112) plaziert sind, wobei der äußere obere Kantenteil (115a) über die Kantenabschnitte der planaren Abdeckung gebogen ist, um den planaren Abdeckungsteil (114a) an dem oberen Teil des Gehäuses (112) zu befestigen.

4. Der Thermistor gemäß Anspruch 1 oder 2, bei dem der obere Kantenteil des Gehäuses (122) nach oben gerichtete Vorstände (122d) auf sich gebildet aufweist, wobei der planare Abdeckungsteil (124a) Durchgangslöcher (124c) hat, die durch denselben entsprechend den Vorständen (122d) gebildet sind, wobei die Vorstände (122d) in die Durchgangslöcher (124c) eingesetzt sind, um den planaren Abdeckungsteil (124a) an dem Gehäuse (122) zu befestigen.

5. Der Thermistor gemäß einem der Ansprüche 1 bis 4, bei dem das erste Anschlußbauglied (111; 124) ein elastisches Material umfaßt, das um 180 Grad gebogen ist, und einen Kontaktpunktteil (111a; 121a) an einem Ende desselben hat, der das Thermistorelement (101) berührt.

6. Der Thermistor gemäß Anspruch 1, bei dem das Thermistorelement (101) ein Thermistorelement mit positivem Temperaturkoeffizienten (PTC) zur Stromsteuerung ist.

7. Der Thermistor gemäß Anspruch 1, bei dem das Thermistorelement (101) ein Thermistorelement mit negativem Temperaturkoeffizienten (NTC) zur Stromsteuerung ist.

8. Der Thermistor gemäß Anspruch 1, bei dem das Thermistorelement (101) ein Kritische-Temperatur-Widerstands- (CTR-) Element zur Stromsteuerung ist.

9. Der Thermistor gemäß Anspruch 1, bei dem das Gehäuse (3) elektrisch isolierend ist und das untere Bauglied eine untere Oberfläche hat;
wobei das erste leitfähige Anschlußbauglied (4) teilweise in dem Gehäuse (3) vergraben ist und einen ersten Kompressionskontaktteil (42) und einen ersten Verbinderteil aufweist, wobei der erste Kompressionskontaktteil die Elektrode auf der unteren Oberfläche auf das Element drückt, wobei der erste Verbinderteil auf der unteren Oberfläche des Gehäuses ist; und
wobei das zweite leitfähige Anschlußbauglied (5) einen zweiten Kompressionskontaktteil (54) und einen zweiten Verbinderteil hat, wobei der zweite Kompressionskontaktteil (54) an einem oberen Teil des Gehäuses (3) angebracht ist und die Elektrode (22, 23) auf der oberen Oberfläche drückt, wobei sich der zweite Verbinderteil (51) auf einer Seitenoberfläche des Gehäuses (3) erstreckt und die untere Oberfläche des Gehäuses erreicht.

10. Der Thermistor gemäß Anspruch 9, bei dem der erste Kompressionskontaktteil (42) zumindest einen Vorstand hat, der auf demselben gebildet ist, zum Drücken der Elektrode auf der unteren Oberfläche.

11. Der Thermistor gemäß Anspruch 9 oder 10, bei dem das Gehäuse (3) gegenseitig gegenüberliegende Seitenwände (3c, 3d) mit an denselben gebildeten Ineingriffnahmevorrichtungen (32, 33) aufweist, wobei das zweite leitfähige Bauglied (5) einen planaren Teil (51) zum Bedecken des Gehäuses (3) von oben und sich vertikal erstreckende Teile (52, 53) aufweist, die die Seitenwände (3c, 3d) bedecken und in die Ineingriffnahmevorrichtungen (32, 33) an den Seitenwänden (3c, 3d) eingreifen.

12. Der Thermistor gemäß Anspruch 11, bei dem das zweite leitfähige Bauglied (5) ein flexibles Material aufweist, wobei der zweite Kompressionskontaktteil (54) von dem planaren Teil um im wesentlichen 180 Grad gebogen ist.

13. Der Thermistor gemäß Anspruch 11 oder 12, bei dem das Gehäuse (3) eine Einrichtung (36, 37) zum Verhindern einer Bewegung des planaren Teils bezüglich desselben aufweist.

## Revendications

1. Thermistance (1, 110 ; 120) pour le montage en surface comprenant :
un élément de thermistance planar (2 ; 101) ayant des électrodes (22, 24 ; 101a, 101b) sur des surfaces principales mutuellement opposées à celles-ci ;
un premier élément de borne conducteur (4 ; 111 ; 121) en contact avec une desdites surfaces principales ;
un boîtier (3 ; 112 ; 122) logeant ledit élément (2 ; 101) avec une ouverture de dessus (31 ; 112a ; 122a) ayant une partie de borne de dessus entourant ladite ouverture de dessus (112a ; 122a) et un élément de fond, une extrémité dudit premier élément de borne (111 ; 121) étant positionnée à l'intérieur dudit boîtier (112 ; 122) au-dessus dudit élément de fond ; et
un second élément de borne conductrice (5 ; 114 ; 124) ayant à une extrémité de celle-ci un couvercle planar (51 ; 114a ; 124a) qui est fixé à ladite partie de bord supérieur dudit boîtier (3 ; 112 ; 122) couvrant ainsi ladite ouverture (3 ; 112a ; 122a) et en contact avec ladite autre surface principale, les autres extrémités desdits premier et second éléments de borne (4, 5 ; 111, 114 ; 121, 124) étant positionnées sous ledit élément de fond.

2. Thermistance selon la revendication 1 dans laquelle ledit premier élément de borne (111 ; 121) a une partie de point de contact (111a ; 121a) qui est à une position élevée à partir dudit élément de fond, ledit élément de thermistance (101) est maintenu à une position élevée à partir dudit élément de fond, et lesdits premier et second éléments de borne (111, 114 ; 121, 124) pour avoir lesdites autres extrémités de ceux-ci positionnées sur une surface de fond dudit élément de fond.

3. Thermistance selon la revendication 1 ou 2, dans laquelle ladite partie de bord de dessus dudit boîtier (112) a une partie de bord de dessus interne (115a) et une partie de bord de dessus externe (115b), ladite partie de bord de dessus interne (115a) étant à l'intérieur et plus petite que ladite partie de bord de dessus externe (115b), les parties de bord de ladite partie de couvercle planar (114a) étant placées sur ladite partie de bord de dessus interne (115a) dudit boîtier (112), ladite partie de bord de dessus externe (115b) étant pliée sur ladite partie de bord dudit couvercle planar pour fixer ladite partie de couvercle planar (114a) à ladite partie de dessus dudit boîtier (112).

4. Thermistance selon la revendication 1 ou 2 dans laquelle ladite partie de bord de dessus du boîtier (122) a des parties faisant saillie vers le haut (122d) formées sur celle-ci, ladite partie de couvercle planar (124a) ayant des trous traversants (124c) formés à travers celle-ci correspondant auxdites parties en saillie (122d), lesdites parties en saillie (122d) étant insérées dans lesdits trous traversants (124c) pour fixer ladite partie de couvercle planar (124a) audit boîtier (122).

5. Thermistance selon l'un quelconque des revendications 1 à 4 dans laquelle ledit premier élément de borne (111 ; 114) comprend un matériau élastique plié de 180°, a une partie de point de contact (111a ; 121a) à une extrémité de celle-ci en contact avec ledit élément de thermistance (101).

6. Thermistance selon la revendication 1 dans laquelle ledit élément de thermistance (101) est un élément de thermistance à coefficient de température positive (PTC) pour une commande de courant.

7. Thermistance selon la revendication 1, dans laquelle ledit élément de thermistance (101) est un élément de thermistance à coefficient de température négative (NTC) pour un courant de commande.

8. Thermistance selon la revendication 1 dans laquelle ledit élément de thermistance (101) est un élément à résistance de température critique (CTR) pour une commande de courant.

9. Thermistance selon la revendication 1, dans laquelle ledit boîtier (3) est isolant électriquement et ledit élément de fond a une surface de fond ;
ledit premier élément de borne conductrice (4) est dans une partie enterrée dans ledit boîtier (3) et comprend une première partie de contact de compression (42) et une première partie de connecteur, ladite première partie de contact de compression pressant ladite électrode de surface inférieure sur ledit élément, ladite première partie de connecteur étant sur ladite surface de fond du boîtier ; et
ledit second élément de borne de conducteur (5) a une seconde partie de contact de compression (54) et une seconde partie de connecteur, ladite seconde partie de contact de compression (54) étant fixée à une partie supérieure dudit boîtier (3) et pressant ladite électrode de surface supérieure (22, 23), ladite seconde partie de connecteur (51) s'étendant sur une surface latérale dudit boîtier (3) et atteignant ladite surface de fond du boîtier.

10. Thermistance selon la revendication 9 dans lequel ladite première partie de contact de compression (42) a au moins une partie faisant saillie formée sur celle-ci pour presser ladite électrode de surface inférieure.

11. Thermistance selon la revendication 9 ou 10, dans lequel ledit boîtier (3) a des parois latérales mutuellement opposées (3c, 3d) ayant des mécanismes de prise (32, 33) sur celles-ci, ledit second élément conducteur (5) ayant une partie planar (51) pour couvrir ledit boîtier (3) à partir du dessus et des parties s'étendant verticalement (52, 53) qui couvrent ladite paroi latérale (3c, 3d) et est en prise avec lesdits mécanismes de prise (32, 33) sur lesdites parois latérales (3c, 3d).

12. Thermistance selon la revendication 11 dans lequel ledit second élément conducteur (5) comprend un matériau souple, ladite seconde partie de contact de compression (54) substantiellement pliée de 180° à partir de ladite partie planar.

13. Thermistance selon la revendication 11 ou 12, dans lequel ledit boîtier (3) comprend un moyen (36, 37) pour empêcher le déplacement de ladite partie planar par rapport à celle-ci.
